# EUROPEAN PATENT APPLICATION

(11) **EP 3 416 203 A1**
(43) Date of publication of application: **19.12.2018**
(21) Application number: 16889881.5
(22) Date of filing: 02.09.2016
(51) Int. Cl.: H01L 33/50

(54) **CERAMIC PLATE, METHOD FOR MANUFACTURING SAME, AND OPTICAL SEMICONDUCTOR DEVICE**

(30) Priority: 09.02.2016 JP 2016023008; 13.05.2016 JP 2016096807
(71) Applicant: Nitto Denko Corporation, Ibaraki-shi Osaka 567-8680 (JP)
(72) Inventor: FUJII, Hironaka, Ibaraki-shi Osaka 567-8680 (JP); AMANO, Yasuhiro, Ibaraki-shi Osaka 567-8680 (JP); IKEMURA, Kazuhiro, Ibaraki-shi Osaka 567-8680 (JP)
(74) Representative: Hoffmann Eitle
(86) International application number: PCT/JP2016/075824
(87) International publication number: WO 2017/138180

(57) **Abstract**

A ceramic plate having a flat plate shape includes a cut-out portion that is cut out inwardly from a peripheral end surface. An end surface defining the cut-put portion inclines in a thickness direction of the ceramic plate.

## Description

### TECHNICAL FIELD

The present invention relates to a ceramic plate, a producing method thereof, and an optical semiconductor device, to be specific, to a ceramic plate, a method for producing the ceramic plate, and an optical semiconductor device including the ceramic plate.

### BACKGROUND ART

Conventionally, it has been known that, together with a radiation emitting semiconductor chip, a luminescence conversion element containing a ceramic material is used for optoelectronics components.

The luminescence conversion element is, for example, formed into an L-shaped plate shape having a cut-out portion (ref: for example, Patent Document 1). In Patent Document 1, an optoelectronics component in which the lower surface of the luminescence conversion element is connected to the upper surface of the radiation emitting semiconductor chip, and a bonding pad provided in an angular domain of the radiation emitting semiconductor chip that is exposed from the cut-out portion is connected by a bonding wire has been proposed.

### Citation List

### Patent Document

Patent Document 1: Japanese Unexamined Patent Application Publication (Translation of PCT Application) No. 2014-502368

### SUMMARY OF THE INVENTION

### PROBLEM TO BE SOLVED BY THE INVENTION

In the optoelectronics component, improvement of the mountability for connecting the bonding pad with the bonding wire has been recently required.

An object of the present invention is to provide a ceramic plate having excellent mountability, a producing method thereof, and an optical semiconductor device.

### MEANS FOR SOLVING THE PROBLEM

The present invention [1] includes a ceramic plate having a flat plate shape including a cut-out portion that is cut out inwardly from a peripheral end surface, wherein an end surface defining the cut-out portion inclines in a thickness direction of the ceramic plate.

The present invention [2] includes the ceramic plate described in [1], wherein as an inclination angle of the end surface, one of the angles formed between the end surface and the upper surface or the lower surface of the ceramic plate to a phantom plane is 30 degrees or more and 89 degrees or less.

The present invention [3] includes the ceramic plate described in [1] or [2], wherein the end surface has a curved shape when viewed from the top.

The present invention [4] includes an optical semiconductor device including an optical semiconductor element and the ceramic plate described in any one of [1] to [3] disposed on one surface of the optical semiconductor element.

The present invention [5] includes the optical semiconductor device described in [4], wherein the ceramic plate is disposed on one surface of the optical semiconductor element so that an angle formed between one surface of the optical semiconductor element and the end surface is an acute angle.

The present invention [6] includes the optical semiconductor device described in [4], wherein the ceramic plate is disposed on one surface of the optical semiconductor element so that an angle formed between one surface of the optical semiconductor element and the end surface is an obtuse angle.

The present invention [7] includes a method for producing a ceramic plate sequentially including the steps of preparing a ceramic sheet, forming a through hole in the ceramic sheet and exposing an end surface defining the through hole, and cutting the ceramic sheet to form a plurality of ceramic plates including the end surface, wherein the end surface inclines in a thickness direction of the ceramic sheet.

The present invention [8] includes the method for producing a ceramic plate described in [7], wherein a side surface exposed at the time of cutting the ceramic sheet inclines in the thickness direction of the ceramic sheet.

### EFFECT OF THE INVENTION

According to the ceramic plate of the present invention, mountability for connecting the bonding pad provided in the optical semiconductor element with the bonding wire is excellent.

According to the method for producing a ceramic plate of the present invention, a ceramic plate having excellent mountability of the bonding wire can be produced.

According to the optical semiconductor device of the present invention, the ceramic plate of the present invention is used, so that a yield is excellent.

### BRIEF DESCRIPTION OF THE DRAWINGS

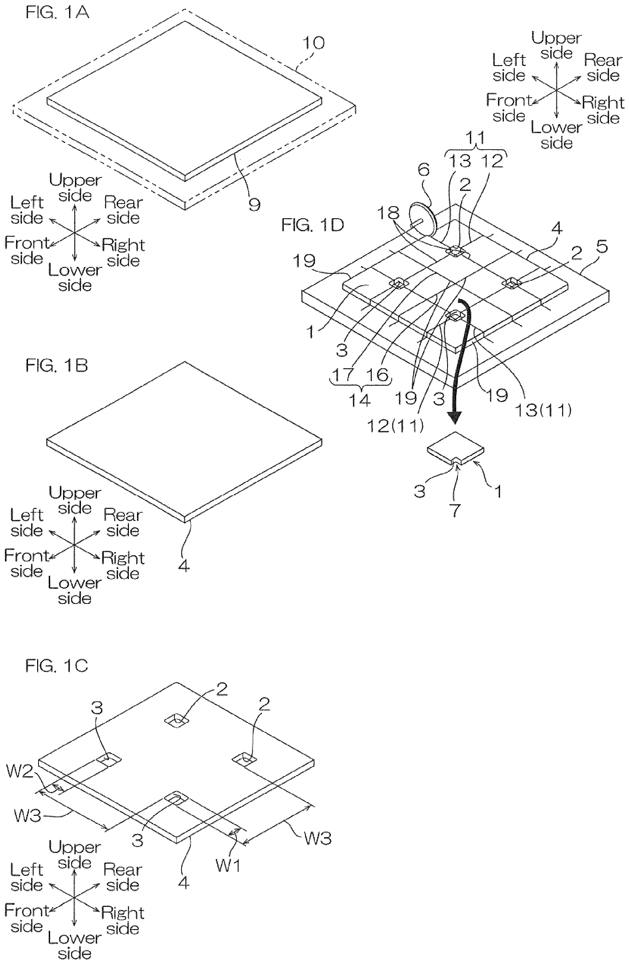

FIGS. 1A to ID show perspective views of process drawings for illustrating one embodiment of a method for producing a ceramic plate of the present invention:
   FIG. 1A illustrating a step of preparing a phosphor green sheet,
   FIG. 1B illustrating a step of calcinating the phosphor green sheet to form a phosphor ceramic sheet,
   FIG. 1C illustrating a step of forming a through hole in the phosphor ceramic sheet, and
   FIG. 1D illustrating a step of cutting the phosphor ceramic sheet with a cutting blade to obtain a plurality of phosphor ceramic plates.
FIG. 2 shows a side cross-sectional view in the through hole in the phosphor ceramic sheet of FIG. 1C.
FIGS. 3A to 3C show one embodiment of the ceramic plate of the present invention:

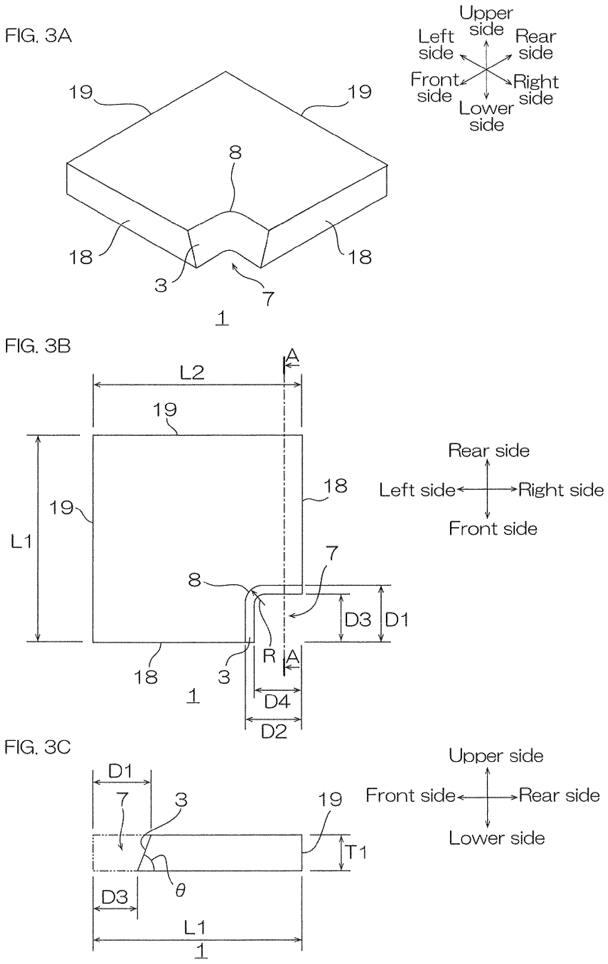

FIG. 3A illustrating a perspective view,
FIG. 3B illustrating a plane view, and
FIG. 3C illustrating a cross-sectional view along A-A of FIG. 3B.

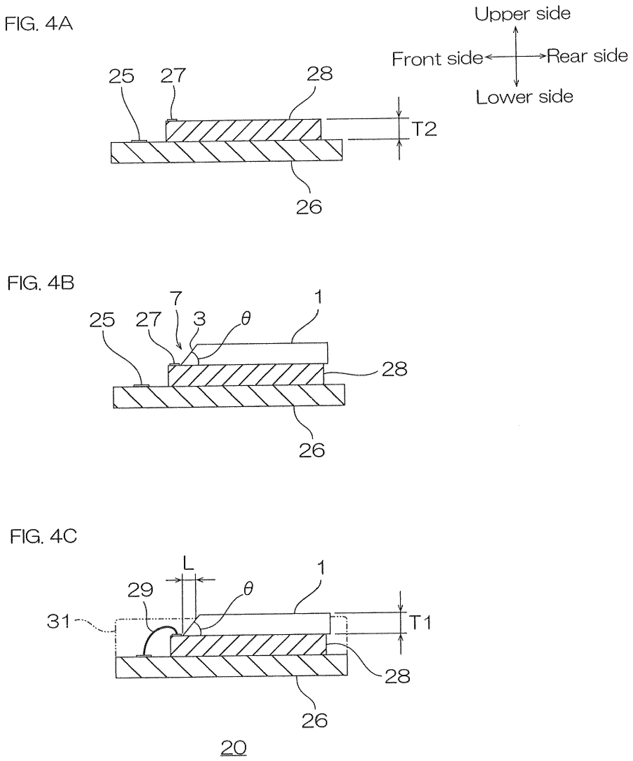

FIGS. 4A to 4C show cross-sectional views of process drawings for producing a first embodiment of an optical semiconductor device of the present invention:
   FIG. 4A illustrating a step of preparing an element-including board,
   FIG. 4B illustrating a step of disposing a phosphor ceramic plate on an optical semiconductor element, and
   FIG. 4C illustrating a step of obtaining the optical semiconductor device by wire bonding.

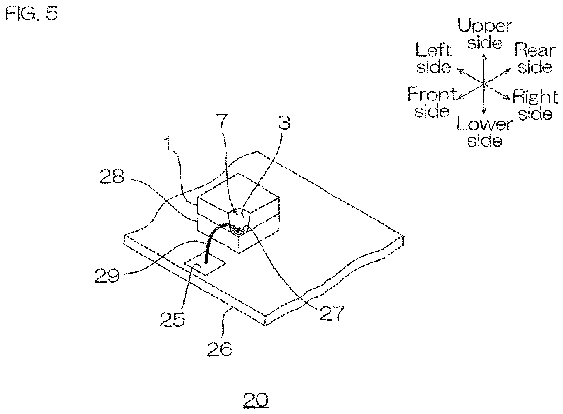

FIG. 5 shows a perspective view of the optical semiconductor device of FIG. 4C.

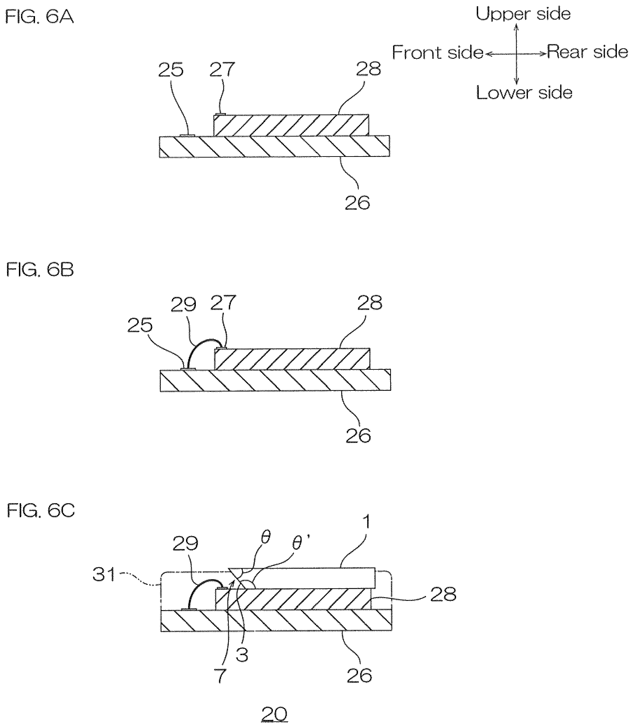

FIGS. 6A to 6C show cross-sectional views of process drawings for producing a second embodiment of an optical semiconductor device of the present invention:
   FIG. 6A illustrating a step of preparing an optical semiconductor element-including board,
   FIG. 6B illustrating a step of wire bonding, and
   FIG. 6C illustrating a step of disposing a phosphor ceramic plate on an optical semiconductor element to obtain the optical semiconductor device.

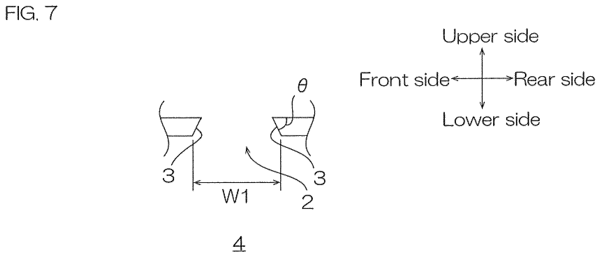

FIG. 7 shows a cross-sectional view of another embodiment of the through hole in the phosphor ceramic sheet shown in FIG. 1C.

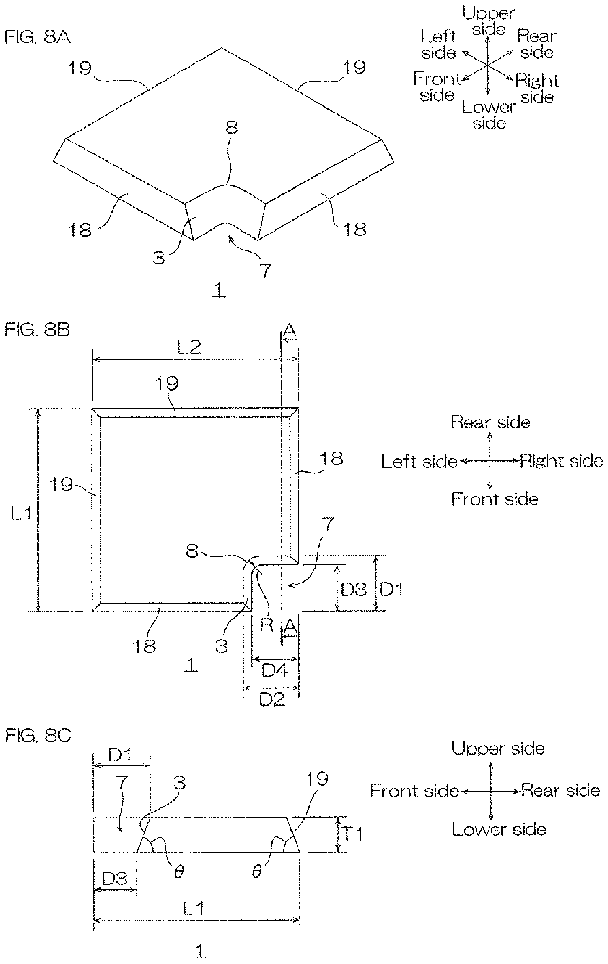

FIGS. 8A to 8C show modified examples of the phosphor ceramic sheet shown in FIG. 1C:
   FIG. 8A illustrating a perspective view,
   FIG. 8B illustrating a plane view, and
   FIG. 8C illustrating a cross-sectional view along A-A of FIG. 8B.

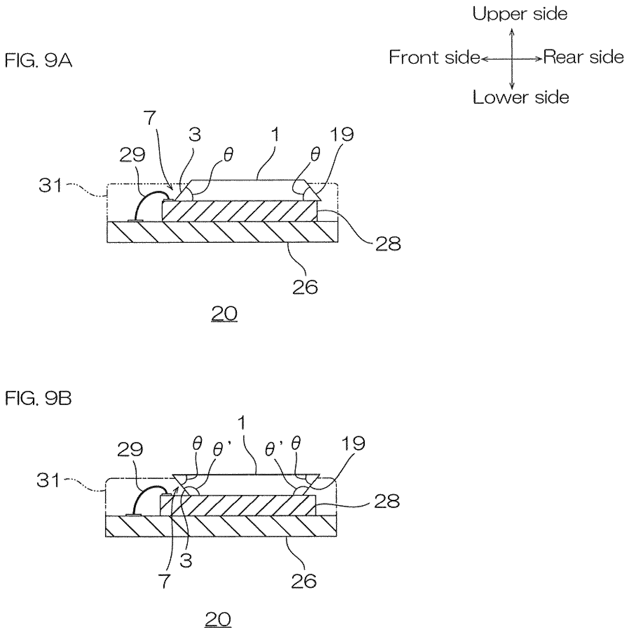

FIGS. 9A to 9B show cross-sectional views of modified examples of an optical semiconductor device of the present invention using the phosphor ceramic sheet shown in FIG. 8A:
   FIG. 9A illustrating a modified example of a first embodiment of the optical semiconductor device and
   FIG. 9B illustrating a modified example of a second embodiment of the optical semiconductor device.

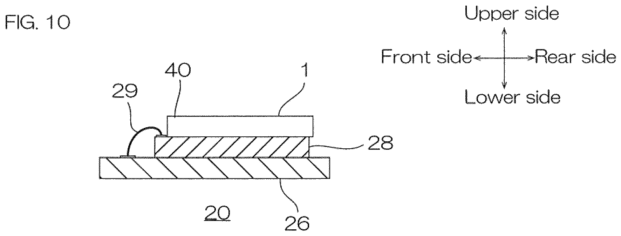

FIG. 10 shows a cross-sectional view of a conventional optical semiconductor device.

### DESCRIPTION OF EMBODIMENTS

### <Phosphor Ceramic Plate>

A phosphor ceramic plate as one embodiment of a ceramic plate of the present invention is described.

### 1. Method for Producing Phosphor Ceramic Plate

First, one embodiment of a method for producing a phosphor ceramic plate 1 (hereinafter, also simply referred to as a phosphor plate 1) that is one embodiment of the present invention is described with reference to FIGS. 1A to 3C.

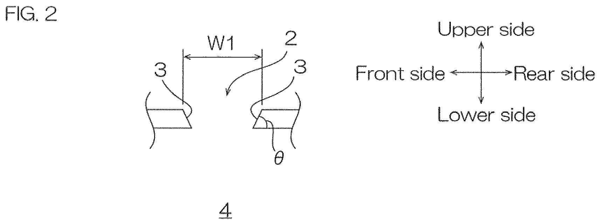

In FIG. 2, the up-down direction of the paper surface is an up-down direction (first direction, thickness direction), the upper side of the paper surface is an upper side (one side in the first direction), and the lower side of the paper surface is a lower side (the other side in the first direction). The right-left direction of the paper surface is a front-rear direction (second direction perpendicular to the first direction), the left side of the paper surface is a front side (one side in the second direction), and the right side of the paper surface is a rear side (the other side in the second direction). The paper thickness direction is a right-left direction (third direction perpendicular to the first and second directions), the near side of the paper surface is a right side (one side in the third direction), and the far side of the paper surface is a left side (the other side in the third direction). Views other than FIG. 2 are also in conformity with directions of FIG. 2.

As shown in FIGS. 1A to 1C, the method for producing the phosphor plate 1 sequentially includes a preparation step of preparing a phosphor ceramic sheet 4 as one embodiment of a ceramic sheet, a through hole forming step of forming through holes 2 in the phosphor ceramic sheet 4 and exposing end surfaces 3 defining the through holes 2, and a cutting step of cutting the phosphor ceramic sheet 4 to form the plurality of phosphor plates 1 including the end surfaces 3. Hereinafter, each of the steps is described in detail.

### (Preparation Step)

In the preparation step, the phosphor ceramic sheet 4 is prepared. To be specific, a phosphor green sheet 9 is prepared, and next, the phosphor green sheet 9 is calcinated.

First, as shown in FIG. 1A, the phosphor green sheet 9 is prepared.

As a method for preparing the phosphor green sheet 9, for example, slurry (slip) molding; compression molding such as cold isostatic pressing (CIP) and hot isostatic pressing (HIP); and injection molding are used. Preferably, in view of thickness accuracy of the phosphor green sheet 9, slurry molding and compression molding are used, more preferably, slurry molding is used.

In the slurry molding, first, for example, a slurry containing a dispersion medium and a phosphor composition containing a phosphor material, organic particles, and a binder is prepared.

The phosphor material is a raw material of a phosphor, and appropriately selected in accordance with the phosphor.

The phosphor has a wavelength conversion function, and examples thereof include a yellow phosphor that is capable of converting blue light into yellow light and a red phosphor that is capable of converting blue light into red light.

Examples of the yellow phosphor include silicate phosphors such as (Ba, Sr, Ca)₂SiO₄:Eu and (Sr,Ba)₂SiO₄:Eu (barium orthosilicate (BOS)); garnet type phosphors having a garnet type crystal structure such as (Y, Gd, Ba, Ca, Lu)₃(Al, Si, Ge, B, P, Ga)₅O₁₂:Ce(YAG (yttrium aluminum garnet):Ce) and Tb₃Al₃O₁₂:Ce (TAG (terbium aluminum garnet):Ce); and oxynitride phosphors such as Ca-α-SiAlON. Examples of the red phosphor include nitride phosphors such as CaAlSiN₃:Eu and CaSiN₂:Eu. Preferably, a garnet type phosphor is used, more preferably, YAG:Ce (Y₃Al₅O₁₂:Ce) is used.

Examples of the phosphor material include a metal simple body that constitutes the phosphor, a metal oxide thereof, and a metal nitride thereof. To be specific, when YAG:Ce is formed as the phosphor, examples of the phosphor material include metal oxides including yttrium-containing compounds such as yttrium oxide, aluminum-containing compounds such as aluminum oxide, and cerium-containing compounds such as cerium oxide. The phosphor material is, for example, formed into a particle shape (or powder shape).

The purity of the phosphor material is, for example, 99.0 mass% or more, preferably 99.9 mass% or more.

The organic particles are contained in the phosphor composition for forming a fine pore (not shown) in the phosphor ceramic sheet 4 as needed. As the organic material that forms the organic particles, a material that is completely thermally decomposed in the calcination (described later) is used. Examples thereof include thermoplastic resins such as acrylic resin (to be specific, methyl polymethacrylate), styrene resin, acrylic-styrene resin, polycarbonate resin, benzoguanamine resin, polyolefin resin, polyester resin, polyamide resin, and polyimide resin and thermosetting resins such as epoxy resin and silicone resin. Preferably, a thermoplastic resin is used, more preferably, an acrylic resin is used. The average particle size of the organic particles is not particularly limited, and for example, 3.4 µm or more, preferably 4.0 µm or more, and for example, 25.0 µm or less, preferably 20.0 µm or less, more preferably 8.0 µm or less.

The content ratio of the organic particles with respect to the total content of the phosphor material and the organic particles is, for example, 1.5% by volume or more, preferably, 2.0% by volume or more, and for example, 12.0% by volume or less, preferably 10.0% by volume or less, more preferably 8.0% by volume or less.

Examples of the binder include resins such as acrylic polymer, butyral polymer, vinyl polymer, and urethane polymer. Also, an example of the binder includes a water-soluble binder. Preferably, an acrylic polymer is used, more preferably, a water-soluble acrylic polymer is used. The content ratio of the binder with respect to 100 parts by volume of the total sum of the phosphor material and the binder is set at, for example, 10 parts by volume or more, preferably 20 parts by volume or more, more preferably, 30 parts by volume or more, and for example, 60 parts by volume or less, preferably 50 parts by volume or less, more preferably 40 parts by volume or less.

The phosphor composition can further contain, for example, additives such as dispersant, plasticizer, and calcination auxiliary as needed.

The dispersion medium is not particularly limited as long as it is capable of dispersing the phosphor material and the organic particles. Examples of the dispersion medium include water and organic dispersion medium such as acetone, methyl ethyl ketone, methanol, ethanol, toluene, methyl propionate, and methyl cellosolve. Preferably, water is used. The content ratio of the dispersion medium with respect to the slurry is, for example, 1 mass% or more and 30 mass% or less.

To prepare the slurry, first, the above-described components are mixed at the above-described ratio, and for example, wet-blended with a ball mill or the like.

When the slurry is prepared, the above-described components may be collectively wet-blended. Or, a preliminary slurry is prepared by wet-blending the components excluding the organic particles and next, the organic particles are wet-blended in the preliminary slurry, so that the slurry can be also prepared.

Subsequently, the slurry is applied to the surface of a peeling sheet 10 to be then dried.

The peeling sheet 10 is formed from a flexible material. Examples of the material include resin sheets including polyester sheets such as polyethylene terephthalate (PET) sheet; polycarbonate sheets; polyolefin sheets such as polyethylene sheet and polypropylene sheet; polystyrene sheets; acrylic sheets; silicone resin sheet; and fluorine resin sheet. Furthermore, examples thereof include metal foils such as copper foil and stainless steel foil. Preferably, a resin sheet is used, further more preferably, a polyester sheet is used. The surface of the peeling sheet 10 may be subjected to release treatment so as to improve the releasability as needed. The thickness of the peeling sheet 10 is, for example, appropriately set in view of handleability and cost, and to be specific, 10 µm or more and 200 µm or less.

As a method for applying the slurry to the peeling sheet 10, application methods such as doctor blade coating, gravure coating, fountain coating, cast coating, spin coating, and roll coating are used.

In this manner, a coating film made from the slurry is formed on the surface of the peeling sheet 10. Subsequently, the coating film is dried.

The drying temperature is, for example, 20°C or more, preferably 50°C or more, and for example, 200°C or less, preferably 150°C or less.

The drying time is, for example, 1 minute or more, preferably 2 minutes or more, and for example, 24 hours or less, preferably 5 hours or less.

In this manner, the phosphor green sheet 9 is obtained in a state of being supported by the peeling sheet 10.

The phosphor green sheet 9 is a sheet of the phosphor ceramic sheet 4 (ref: FIG. 1B) before the calcination, and has a plate shape extending in the front-rear and right-left directions.

Thereafter, the peeling sheet 10 is peeled from the phosphor green sheet 9.

Thereafter, if necessary, to obtain a desired thickness, the plurality (plural layers) of phosphor green sheets 9 are laminated by heat lamination, so that a phosphor green sheet laminate 9 can be also obtained.

The thickness of the phosphor green sheet 9 (or the phosphor green sheet laminate 9) is, for example, 10 µm or more, preferably 30 µm or more, and for example, 500 µm or less, preferably 200 µm or less.

Next, as shown in FIG. 1B, the phosphor green sheet 9 is calcinated.

The calcination temperature is, for example, 1300°C or more, preferably 1500°C or more, and for example, 2000°C or less, preferably 1800°C or less.

The calcination time is, for example, 1 hour or more, preferably 2 hours or more, and for example, 24 hours or less, preferably 8 hours or less.

The temperature rising rate in the calcination is, for example, 0.5°C/min or more and 20°C/min or less.

Before the above-described calcination (main calcination), organic component-removing treatment can be also performed in which preliminary heating is performed in the air at, for example, 600°C or more and 1300°C or less by using an electric furnace so as to thermally decompose and remove organic components such as binder and dispersant.

The phosphor ceramic sheet 4 after the calcination (ref: FIG. 1B) contracts with respect to the phosphor green sheet 9 before the calcination (ref: FIG. 1B). A thickness T1 of the phosphor ceramic sheet 4 after the calcination with respect to the phosphor green sheet 9 before the calcination is, for example, 99% or less, preferably 95% or less, more preferably 90% or less, and for example, 60% or more.

To be specific, the thickness T1 of the phosphor ceramic sheet 4 after the calcination is, for example, 0.03 mm or more, preferably 0.05 mm or more, and for example, 1.0 mm or less, preferably 0.3 mm or less.

A plurality of fine pores (not shown) are formed in the phosphor ceramic sheet 4. The average pore size is, for example, 2.5 µm or more, preferably 3.0 µm or more, more preferably 3.5 µm or more, and for example, 20.0 µm or less, preferably 16.0 µm or less, more preferably 10.0 µm or less.

### (Through Hole Forming Step)

In the through hole forming step, as shown in FIG. 1C, the through holes 2 are formed in the phosphor ceramic sheet 4.

As a method for forming the through holes 2, for example, blasting is used. Examples of the blasting include direct pressure blasting process and siphon process.

In the blasting, to be specific, by disposing a resist in the phosphor ceramic sheet 4, a portion other than the portion in which the through hole 2 is provided is covered with the resist, and thereafter, an injection material is injected to the phosphor ceramic sheet 4.

By appropriately adjusting the type and the particle size of the injection material, the injection rate, the method (direct pressure, siphon type), or the like used in the blasting, the size of the through hole 2, an inclination angle (θ) of the end surface 3, or the like can be appropriately adjusted.

By forming the plurality of through holes 2 in the phosphor ceramic sheet 4, each of the plurality of end surfaces 3 that defines each of the plurality of through holes 2 is formed in the phosphor ceramic sheet 4. That is, in the through hole forming step, the through hole 2 and the end surface 3 are simultaneously formed.

In the phosphor ceramic sheet 4, the plurality (2 rows in the front-rear direction, 2 rows in the right-left direction) of through holes 2 are disposed in alignment at spaced intervals to each other in the front-rear and right-left directions.

The through hole 2 passes through the phosphor ceramic sheet 4 in the thickness direction (up-down direction). The through hole 2 has a generally rectangular shape when viewed from the top (to be specific, generally square shape when viewed from the top). To be more specific, in the generally rectangular shape of the through hole 2, all (four pieces) of the edge portions (corners) are round. That is, all of the edge portions are formed in a circular arc shape. As shown in FIG. 2, the through hole 2 has a generally tapered shape when viewed in cross section in which the width thereof is gradually narrow downwardly, while retaining a generally rectangular shape when viewed from the top.

The end surface 3 defines the inner periphery surface of the through hole 2. As shown in FIG. 2, the end surface 3 inclines in the thickness direction (up-down direction) in the phosphor ceramic sheet 4 (consequently, the phosphor plate 1 to be described later) when viewed in cross section. The inclination angle θ formed between the end surface 3 and the lower surface of the phosphor ceramic sheet 4 is an acute angle, and the details thereof are described later.

The size of the through hole 2 is appropriately set in accordance with the size of a connecting portion 27 and a wire 29 of an optical semiconductor device 20 (ref: FIG. 3C) to be described later. To be specific, the length of the through hole 2 (length W1 in the front-rear direction or length W2 in the right-left direction) is, for example, 0.1 mm or more, preferably 0.3 mm or more, and for example, 5.0 mm or less, preferably 1.0 mm or less. A pitch (W3) between the through holes 2 that are next to each other, that is, a gap from one end of the through hole 2 to one end of the through hole 2 that is next thereto is, for example, 0.1 mm or more, preferably 1 mm or more, and for example, 20 mm or less, preferably 10 mm or less.

### (Cutting Step)

As shown in FIG. 1D, in the cutting step, first, the phosphor ceramic sheet 4 is supported by a supporting sheet 5.

An example of the supporting sheet 5 includes a dicing tape having slight pressure-sensitive adhesive properties in which the supporting sheet 5 is supported so as to surely cut the phosphor ceramic sheet 4 and then, the cut phosphor ceramic sheet 4 (to be specific, the phosphor plate 1) is capable of being peeled. The size of the supporting sheet 5 is appropriately adjusted in accordance with the size of the phosphor ceramic sheet 4. The length in the front-rear direction and the length in the right-left direction of the supporting sheet 5 are, for example, long with respect to those of the phosphor ceramic sheet 4.

Next, in the cutting step, the phosphor ceramic sheet 4 is cut, and the plurality of phosphor plates 1 including the end surface 3 are formed.

To be specific, the phosphor ceramic sheet 4 is cut by a cutting blade 6.

As shown in FIG. 1D, examples of the cutting blade 6 include a dicing saw (dicing blade) having a disk shape and rotatable with respect to its axis and a cutter (not shown) having a blade edge along the generally horizontal direction. As the cutting blade 6, preferably, a dicing saw is used.

To be specific, to cut the phosphor ceramic sheet 4, for example, a dicing device including the dicing saw and a cutting device including a cutter (not shown) are used. Preferably, a dicing device is used.

The phosphor ceramic sheet 4 is cut so that first cutting lines 11 formed by the above-described cutting blade 6 go through the plurality of through holes 2, thereby producing the phosphor plates 1. To be specific, the phosphor ceramic sheet 4 is cut so that the end surface 3 that defines one through hole 2 is distributed to each of the plurality of phosphor plates 1 to divide one end surface 3. Specifically, the phosphor ceramic sheet 4 is cut so that the end surface 3 that defines one through hole 2 is distributed to each of the four phosphor plates 1 to divide one end surface 3 into 4 pieces.

To be specific, the phosphor ceramic sheet 4 is cut so that the first cutting lines 11 go through each of the centers of the plurality of through holes 2. Then, one end surface 3 is divided into a plurality of pieces.

The first cutting lines 11 have first front-rear cutting lines 12 that extend in the front-rear direction and are disposed at spaced intervals to each other in the right-left direction, and first right-left cutting lines 13 that extend in the right-left direction and are disposed at spaced intervals to each other in the front-rear direction.

The first front-rear cutting line 12 and the first right-left cutting line 13 cross to be perpendicular to each other at each of the centers of the plurality of through holes 2.

Along with the cutting of the phosphor ceramic sheet 4 along the first cutting lines 11, the cutting of the phosphor ceramic sheet 4 along second cutting lines 14 is performed.

The second cutting lines 14 do not go through the through holes 2 and to be specific, go through between the through holes 2 that are next to each other. The second cutting lines 14 have second front-rear cutting lines 16 that extend in the front-rear direction in parallel with the first front-rear cutting lines 12 next thereto, and second right-left cutting lines 17 that extend in the right-left direction in parallel with the first right-left cutting lines 13 next thereto.

The second front-rear cutting lines 16 and the first front-rear cutting lines 12 are alternately disposed at equal intervals in the right-left direction. The second right-left cutting lines 17 and the first right-left cutting lines 13 are alternately disposed at equal intervals in the front-rear direction.

By cutting the phosphor ceramic sheet 4 along the first cutting lines 11 and the second cutting lines 14 described above, the plurality of phosphor plates 1 can be obtained in a state of being supported by the upper surface of the supporting sheet 5. Next, each of the plurality of phosphor plates 1 is peeled from the supporting sheet 5 by, for example, a pickup device including a collet (not shown).

In this manner, the plurality of phosphor plates 1 in singulated pieces can be obtained.

### 2. Phosphor Ceramic Plate (Phosphor Plate)

As shown in FIGS. 3A to 3C, the phosphor plate 1 has a flat plate shape having a flat upper face and a flat lower face. The peripheral side surface of the phosphor plate 1 has the end surface 3 divided from the end surface 3 of one through hole 2, two first side surfaces 18 (two side surfaces) continuous to both end portions of the end surface 3 along the two first cutting lines 11 that are perpendicular to each other, and two second side surfaces 19 (two side surfaces) along the two second cutting lines 14 that are perpendicular to each other or the peripheral side surface of the phosphor ceramic sheet 4 and continuous to both end portions of the first side surface 18.

As shown in FIG. 3B, the phosphor plate 1 has a generally rectangular shape when viewed from the top (to be specific, generally square shape when viewed from the top). The phosphor plate 1 has a cut-out portion 7 formed by dividing one through hole 2 into four pieces.

The cut-out portion 7 is formed by being cut out inwardly from the peripheral end surface of the edge portion (corner) of the phosphor plate 1 into a generally rectangular shape when viewed from the top (generally square shape when viewed from the top). That is, the cut-out portion 7 is formed into a generally rectangular shape when viewed from the top at the edge portion of the phosphor plate 1.

As shown in FIG. 3C, the end surface 3 that defines the cut-out portion 7 inclines in the thickness direction (up-down direction) of the phosphor plate 1 when viewed in cross section. As shown in FIG. 3B, an edge portion 8 of the end surface 3 has a curved shape when viewed from the top. To be specific, the end surface 3 has a generally L-shape having a predetermined width when viewed from the top, and the edge portion 8 in an L-shape when viewed from the top is formed to be round, that is, in a circular arc shape.

The first side surface 18 and the second side surface 19 are, when viewed in cross section, along the thickness direction of the phosphor plate 1 and perpendicular to the plane direction (front-rear and right-left directions) of the phosphor plate 1.

Each of the sizes of the plurality of phosphor plates 1 is appropriately set in accordance with the size of an optical semiconductor element 28 to be described later. A length L1 in the front-rear direction and a length L2 in the right-left direction of the phosphor plate 1 are, for example, 0.1 mm or more, preferably 0.5 mm or more, and for example, 10 mm or less, preferably 2.0 mm or less. The thickness thereof is the same as the above-described thickness T1 of the phosphor ceramic sheet 4.

A radius of curvature R of the edge portion 8 of the end surface 3 is, for example, 0.01 mm or more, preferably 0.05 mm or more, and for example, 0.20 mm or less, preferably 0.15 mm or less.

The inclination angle θ of the end surface 3 with respect to the lower surface of the phosphor plate 1 is, for example, 30 degrees or more, preferably 51 degrees or more, and for example, 89 degrees or less, preferably 80 degrees or less. By setting the inclination angle θ of the end surface 3 within the above-described range, at the time of mounting of the optical semiconductor device 20, the visibility and the wire bonding workability of the connecting portion 27 are improved, and a contact failure of the wire 29 can be improved. Furthermore, by setting the inclination angle θ of the end surface 3 at 51 degrees or more, the area having a change of color (blue edge) that occurs at the peripheral end edge of the phosphor plate 1 can be reduced, so that the light emitting properties are excellent.

In the above-described description, the inclination angle θ is the angle formed between the lower surface of the phosphor plate 1 and the end surface 3. Also, the inclination angle sheet is defined as a smaller angle (acute angle) of the angle formed between the lower surface of the phosphor plate 1 and the end surface 3, and the angle formed between the upper surface of the phosphor plate 1 and the end surface 3.

A length D1 in the front-rear direction and a length D2 in the right-left direction of the upper end of the cut-out portion 7 (that is, the length in the front-rear direction and the length in the right-left direction in the case of the longest in the cut-out portion 7) are, for example, 0.05 mm or more, preferably 0.10 mm or more, and for example, 1.0 mm or less, preferably 0.5 mm or less.

The ratio of a length D3 in the front-rear direction and a length D4 in the right-left direction of the lower end of the cut-out portion 7 (that is, the length in the front-rear direction and the length in the right-left direction in the case of the shortest in the cut-out portion 7) with respect to D1 and D2 of the upper end thereof is, for example, 95% or less, preferably 90% or less, and for example, 40% or more, preferably 50 % or more. To be specific, the length D3 in the front-rear direction and the length D4 in the right-left direction of the lower end of the cut-out portion 7 is, for example, 0.03 mm or more, preferably 0.05 mm or more, and for example, 1.0 mm or less, preferably 0.5 mm or less.

The phosphor plate 1 is not the optical semiconductor device 20 to be described next in FIG. 4C. The phosphor plate 1 is one component of the optical semiconductor device 20, that is, a component for producing the optical semiconductor device 20 and does not include an optical semiconductor element 28. The phosphor plate 1 whose component alone is circulated is an industrially available device, but its uses is not limited to this.

### 3. First Embodiment of Optical Semiconductor Device and Producing Method Thereof

By using the phosphor plate 1, a method for producing the optical semiconductor device 20 of the first embodiment of the present invention is described.

First, as shown in FIG. 4A, an element-including board 30 that includes a board 26 and the optical semiconductor element 28 is prepared.

The board 26 has a generally plate shape and is, for example, made from an insulating material. A conductive pattern including a terminal portion 25 is formed on the upper surface of the board 26.

The optical semiconductor element 28 is fixed to the upper surface of the board 26 and is disposed at spaced intervals to the terminal portion 25. The optical semiconductor element 28 has a generally rectangular plate shape and is made from an optical semiconductor material. A connecting portion (terminal) 27 for wire bonding is formed at one edge portion (corner) on the upper surface (one surface) of the optical semiconductor element 28.

The element-including board 30 is produced by a step of preparing the board 26 and a step of mounting the optical semiconductor element 28 on the upper surface of the board 26.

Next, as shown in FIG. 4B, the phosphor plate 1 is disposed on the upper surface of the optical semiconductor element 28.

To be specific, the phosphor plate 1 is disposed on the upper surface of the optical semiconductor element 28 so that the angle formed between the upper surface of the optical semiconductor element 28 and the end surface 3 is an acute angle.

The phosphor plate 1 is disposed so that the connecting portion 27 is exposed. That is, the phosphor plate 1 is disposed so that the cut-out portion 7 includes the connecting portion 27 when projected in the thickness direction.

Furthermore, the phosphor plate 1 is disposed so that, in a portion excluding the cut-out portion 7, the phosphor plate 1 includes the optical semiconductor element 28 when projected in the thickness direction. That is, in the portion excluding the cut-out portion 7, the peripheral end edge of the phosphor plate 1 is positioned outwardly with respect to the peripheral end edge of the optical semiconductor element 28.

At this time, by interposing an adhesive that is not shown between the phosphor plate 1 and the optical semiconductor element 28, the phosphor plate 1 is fixed to the optical semiconductor element 28 via the adhesive.

Next, as shown in FIG. 4C, the connecting portion 27 of the optical semiconductor element 28 is wire bonded to the terminal portion 25 of the board 26.

To be specific, one end portion of the wire 29 is connected to the connecting portion 27, and the other end portion of the wire 29 is connected to the terminal portion 25.

At this time, the wire 29 is disposed so as to sag in a generally U-shape having an opening downwardly. The wire 29 is disposed so that the upper end thereof is positioned at the upper side with respect to the upper surface of the optical semiconductor element 28.

In this manner, the optical semiconductor device 20 of the first embodiment is obtained.

The optical semiconductor device 20 of the first embodiment includes the board 26 having the terminal portion 25, the optical semiconductor element 28 disposed on the upper surface of the board 26 and having the connecting portion 27, the phosphor plate 1 disposed on the upper surface of the optical semiconductor element 28, and the wire 29 connecting the connecting portion 27 to the terminal portion 25.

The phosphor plate 1 is disposed on the upper surface of the optical semiconductor element 28 so that the angle formed between the upper surface of the optical semiconductor element 28 and the end surface 3 is an acute angle. The angle of the above-described acute angle is the same as the inclination angle θ of the end surface 3.

Next, as shown by a phantom line of FIG. 4C, a light reflective layer 31 is disposed in the optical semiconductor device 20 as needed.

To be specific, the light reflective layer 31 is disposed so as to cover the connecting portion 27 and the peripheral side surface of the optical semiconductor element 28, the peripheral side surface of the phosphor plate 1, and the wire 29 and to expose the upper surface of the phosphor plate 1.

Examples of a method for disposing the light reflective layer 31 include a method in which after a liquid reflective resin composition containing a light reflective component (for example, aluminum oxide, titanium oxide) and a curable resin (for example, thermosetting resins such as silicone resin) is applied or subjected to potting onto the board 26 of the optical semiconductor device 20, the reflective resin composition cures and a method in which after the light reflective layer 31 prepared from a semi-cured reflective resin composition is transferred to the optical semiconductor device 20, the light reflective layer 31 completely cures.

According to the method for producing the first embodiment of the optical semiconductor device 20, the mountability for connecting the connecting portion 27 of the optical semiconductor element 28 to the terminal portion 25 of the board 26 with the wire 29 is excellent.

That is, by the conventional method, as shown in FIG. 10, at the time of the wire bonding, the end surface 3 of the cut-out portion 7 is formed so as to be vertical (that is, θ is 90 degrees) with respect to the upper and lower surfaces of the optical semiconductor device 20. Thus, for example, in FIG. 10, when the wire bonding is performed from the upper rear side, an upper end portion 40 of the edge portion of the phosphor plate 1 becomes an obstacle, so that the visibility of the connecting portion 27 and the wire bonding workability thereto are reduced.

Meanwhile, in the producing method of the first embodiment, in the phosphor plate 1, the cut-out portion 7 that is cut out inwardly from the edge portion in a generally rectangular shape when viewed from the top is provided, and the end surface 3 that defines the cut-out portion 7 inclines in the up-down direction. The phosphor plate 1 is disposed on the upper surface of the optical semiconductor element 28 so that the angle θ formed between the upper surface of the optical semiconductor element 28 and the end surface 3 is an acute angle. Thus, the upper end portion 40 of the edge portion of the phosphor plate 1 does not exist. As a result, the visibility of the connecting portion 27 from the obliquely upper side is ensured. The workability of the wire bonding with respect to the connecting portion 27 is excellent.

The edge portion 8 in the end surface 3 of the cut-out portion 7 of the phosphor plate 1 has a curved shape when viewed from the top. Thus, compared to a case where the edge portion 8 of the end surface 3 is in a right angle shape when viewed from the top, the stress concentration with respect to the edge portion 8 of the end surface 3 is relaxed. As a result, an occurrence of a crack can be suppressed.

Accordingly, the optical semiconductor device 20 of the first embodiment obtained by the producing method has an excellent yield.

### 4. Second Embodiment of Optical Semiconductor Device and Producing Method Thereof

By using the phosphor plate 1, a method for producing the optical semiconductor device 20 of the second embodiment of the present invention is described.

First, as shown in FIG. 6A, the element-including board 30 that includes the board 26 and the optical semiconductor element 28 is prepared. This step is the same as that in the first embodiment.

Next, as shown in FIG. 6B, the connecting portion 27 of the optical semiconductor element 28 is wire bonded to the terminal portion 25 of the board 26. The method for wire bonding is the same as that in the first embodiment.

Next, as shown in FIG. 6C, the phosphor plate 1 is disposed on the upper surface of the optical semiconductor element 28.

To be specific, the phosphor plate 1 is disposed on the upper surface of the optical semiconductor element 28 so that the angle (θ') formed between the upper surface of the optical semiconductor element 28 and the end surface 3 is an obtuse angle.

The phosphor plate 1 is disposed so as to expose the connecting portion 27. That is, the phosphor plate 1 is disposed so that the cut-out portion 27 includes the connecting portion 27 when projected in the thickness direction.

Furthermore, the phosphor plate 1 is disposed so that, in a portion excluding the cut-out portion 7, the phosphor plate 1 includes the optical semiconductor element 28 when projected in the thickness direction. That is, in the portion excluding the cut-out portion 7, the peripheral end edge of the phosphor plate 1 is positioned outwardly with respect to the peripheral end edge of the optical semiconductor element 28.

At this time, by interposing an adhesive that is not shown between the phosphor plate 1 and the optical semiconductor element 28, the phosphor plate 1 is fixed to the optical semiconductor element 28 via the adhesive.

In this manner, the optical semiconductor device 20 of the second embodiment is obtained.

The optical semiconductor device 20 of the second embodiment includes the board 26 having the terminal portion 25, the optical semiconductor element 28 disposed on the upper surface of the board 26 and having the connecting portion 27, the phosphor plate 1 disposed on the upper surface of the optical semiconductor element 28, and the wire 29 connecting the connecting portion 27 to the terminal portion 25.

The phosphor plate 1 is disposed on the upper surface of the optical semiconductor element 28 so that the angle (θ') formed between the upper surface of the optical semiconductor element 28 and the end surface 3 is an obtuse angle. The angle θ' of the above-described obtuse angle is, for example, 91 degrees or more, preferably 100 degrees or more, and for example, 150 degrees or less, preferably 129 degrees or less.

The phosphor plate 1 is disposed so that, in a portion excluding the cut-out portion 7, the phosphor plate 1 includes the optical semiconductor element 28 when projected in the thickness direction. That is, in the portion excluding the cut-out portion 7, the peripheral end edge of the phosphor plate 1 is positioned outwardly with respect to the peripheral end edge of the optical semiconductor element 28.

Next, as shown by the phantom line of FIG. 6C, the light reflective layer 31 is disposed in the optical semiconductor device 20 as needed.

According to the method for producing the second embodiment of the optical semiconductor device 20, the mountability for connecting the connecting portion 27 of the optical semiconductor element 28 to the terminal portion 25 of the board 26 with the wire 29 is excellent.

That is, by the conventional method, as shown in FIG. 10, at the time of the wire bonding, the end surface 3 of the cut-out portion 7 is formed so as to be vertical (that is, θ is 90 degrees) with respect to the upper and lower surfaces of the optical semiconductor device 20. Thus, for example, in a case where the phosphor plate 1 is disposed after the wire bonding, when the position of the phosphor plate 1 deviates, there is a disadvantage (contact failure) that the phosphor plate 1 is brought into contact with the foot of the wire 29 (that is, near the portion bonded to the terminal portion 25), and the wire 29 is dislocated from the terminal portion 25.

Meanwhile, in the producing method of the second embodiment, in the phosphor plate 1, the cut-out portion 7 that is cut out inwardly from the edge portion in a generally rectangular shape when viewed from the top is provided, and the end surface 3 that defines the cut-out portion 7 inclines in the up-down direction. The phosphor plate 1 is disposed on the upper surface of the optical semiconductor element 28 so that the angle θ' formed between the upper surface of the optical semiconductor element 28 and the end surface 3 is an obtuse angle. Thus, the lower surface of the phosphor plate 1 can widen the distance with respect to the connecting portion 27, so that the contact of the phosphor plate 1 on the foot of the wire 29 can be suppressed. As a result, the contact failure can be suppressed.

The edge portion 8 in the end surface 3 of the cut-out portion 7 of the phosphor plate 1 has a curved shape when viewed from the top. Thus, compared to a case where the edge portion 8 of the end surface 3 is in a right angle shape when viewed from the top, the stress concentration with respect to the edge portion 8 of the end surface 3 is relaxed. As a result, an occurrence of a crack can be suppressed.

Accordingly, the optical semiconductor device 20 of the second embodiment obtained by the producing method has an excellent yield.

### 5. Modified Examples

In the modified examples, the same reference numerals are provided for members and steps as those in the above-described embodiment, and their detailed description is omitted.

### (1) Forming Method of Through Hole

In the above-described embodiment, the through hole 2 is formed by the blasting. Alternatively, for example, the through hole 2 can be also formed by laser processing.

As the laser processing, preferably, an ultrashort pulse later is used, more preferably, a picosecond laser and a femtosecond laser are used.

As shown in FIG. 7, by applying a laser from the upper side to the phosphor ceramic sheet by using the laser processing, the through hole 2 having a generally tapered shape when viewed in cross section in which the width thereof is gradually narrow upwardly, while retaining a generally rectangular shape when viewed from the top, can be formed.

By appropriately adjusting an output, a frequency, and a pulse width of a laser oscillator used in the laser processing, the size, the inclination angle, or the like of the through hole can be appropriately adjusted.

In view of productivity, preferably, the blasting is used.

### (2) Shape of Phosphor Plate

As shown in FIG. 1D, in the above-described embodiment, the shape of the phosphor plate 1 when viewed from the top is a generally square shape. Alternatively, for example, though not shown, the shape of the phosphor plate 1 when viewed from the top can be also a rectangular shape other than the square shape; a polygonal shape such as pentagonal shape and hexagonal shape; or a circular arc shape.

As shown in FIG. 4C, in the above-described embodiment, in the optical semiconductor device 20, the phosphor plate 1 is disposed so that, in a portion excluding the cut-out portion 7, the phosphor plate 1 includes the optical semiconductor element 28 when projected in the thickness direction. Alternatively, for example, though not shown, the phosphor plate 1 can be also disposed so that, in the portion excluding the cut-out portion 7, the phosphor plate 1 corresponds to (coincides with) the optical semiconductor element 28 when projected in the thickness direction. That is, in the portion excluding the cut-out portion 7, the peripheral end edge of the phosphor plate 1 can also correspond to the peripheral end edge of the optical semiconductor element 28.

### (3) Number, Position, and Shape of Cut-Out Portion

As shown in FIG. 3A, in the above-described embodiment, the cut-out portion 7 is formed only in one edge portion (corner) of the phosphor plate 1. Alternatively, for example, though not shown, the cut-out portion 7 can be also formed in the plurality of edge portions. The position of the cut-out portion 7 can be also formed in a position other than the edge portion, for example, midway in the front-rear direction or midway in the right-left direction of each of the sides.

In the above-described embodiment, the shape of the cut-out portion 7 when viewed from the top is a generally square shape. Alternatively, for example, though not shown, the shape of the cut-out portion 7 when viewed from the top can be also a rectangular shape other than the square shape; a polygonal shape such as pentagonal shape and hexagonal shape; or a circular arc shape.

### (4) Number of Through Hole

In the through hole forming step, the number of the through hole 2 is not limited to four, and may be three or less and four or more. The number and the position of the second front-rear cutting line and the second right-left cutting line are appropriately adjusted in accordance with the number of the through hole 2.

### (5) Cutting Step

As shown in FIG. 1D, in the above-described embodiment, in the cutting step, the phosphor ceramic sheet 4 is cut by the cutting blade 6. Alternatively, for example, as referred to FIGS. 8A to 8C, the phosphor ceramic sheet 4 can be cut by the blasting. That is, the first cutting line 11 and the second cutting line 14 can be also formed by the blasting. The blasting is the same method as that described in forming the through hole 2.

In the phosphor plate 1 thus obtained shown in FIGS. 8A to 8C, the first side surface 18 and the second side surface 19 incline in the thickness direction (up-down direction) of the phosphor plate 1 when viewed in cross section. The inclination angle of the first side surface 18 and the second side surface 19 is the same inclination angle θ as that of the end surface 3.

By using the phosphor plate 1 shown in FIGS. 8A to 8C, the optical semiconductor device 20 shown in FIG. 9A or FIG. 9B can be also produced in the same manner as the producing method shown in FIGS. 4A to 4C or the producing method shown in FIGS. 6A to 6B.

In the phosphor plate 1 shown in FIGS. 8A to 8C, the forming of the through hole 2 and the cutting of the phosphor ceramic sheet 4 can be performed by the same method, that is, the blasting, so that the productivity is excellent.

In the above-described embodiment, in the cutting step, as shown in FIG. 1D, the phosphor ceramic sheet 4 is cut by the cutting blade 6. Alternatively, though not shown, the phosphor ceramic sheet 4 can be also subjected to scribing and breaking. Also, the phosphor ceramic sheet 4 can be cut by a laser.

### <Another Embodiment>

In the above-described embodiment, the phosphor ceramic plate as one embodiment of the ceramic plate of the present invention, and the optical semiconductor device including the phosphor ceramic plate are described. Alternatively, though not shown, an optical ceramic plate without containing a phosphor is used as one embodiment of the ceramic plate of the present invention. An example of the optical ceramic plate includes a light diffusing layer. In the light diffusing layer, for example, a light reflective component prepared from inorganic particles such as titanium oxide and aluminum oxide is used instead of the phosphor material.

In the embodiment, the same function and effect as that in the above-described embodiment is developed.

### Examples

The specific numerical values in mixing ratio (content ratio), property value, and parameter used in the following description can be replaced with upper limit values (numerical values defined as "or less" or "below") or lower limit values (numerical values defined as "or more" or "above") of corresponding numerical values in mixing ratio (content ratio), property value, and parameter described in the above-described "DESCRIPTION OF EMBODIMENTS".

### Example 1

### (Preparing Step)

A powder of a phosphor material prepared from 11.34 g of yttrium oxide particles (purity of 99.99%, manufactured by NIPPON YTTRIUM CO., LTD.), 8.577 g of aluminum oxide particles (purity of 99.99%, manufactured by Sumitomo Chemical Co., Ltd.), and 0.087 g of cerium oxide particles was prepared.

Next, 20 g of the powder of the phosphor material and a water-soluble binder ("WB4101", manufactured by Polymer Inovations, Inc.) were mixed so that the volume ratio of the solid content was 62:38, and furthermore, distilled water was added thereto to be put in an alumina-made vessel. A zirconia ball having a diameter of 3 mm was added thereto to be wet-blended for 24 hours with a ball mill, thereby preparing a preliminary slurry.

Next, organic particles (methyl polymethacrylate, average particle size of 3.5 µm) were added to the preliminary slurry so that the content ratio thereof with respect to the total content of the phosphor material and the organic particles was 3.0% by volume, and the obtained mixture was further wet-blended, thereby preparing a slurry.

Next, the slurry was applied to the surface of a peeling sheet made of a PET sheet by a doctor blade method to be dried at 70°C for 5 minutes, thereby obtaining the phosphor green sheet 9 having a thickness of 55 µm (ref: FIG. 1A).

Thereafter, the phosphor green sheet 9 was peeled from the PET sheet and subsequently, the phosphor green sheet 9 was cut into a piece having a size of 20 mm × 20 mm. Two pieces of cut phosphor green sheet 9 were laminated to be subjected to heat lamination by using a hot press, thereby producing the phosphor green sheet laminate 9 having a thickness of 110 µm.

Next, the phosphor green sheet laminate 9 was heated (preliminarily heated) until 1200°C at a temperature rising rate of 2°C/min in the air with an electric muffle furnace, so that the water-soluble binder and the organic particles were thermally decomposed and removed.

Thereafter, the phosphor green sheet laminate 9 was moved into a high temperature environment furnace to be heated until 1800°C at a temperature rising rate of 5°C/min under a reducing atmosphere and calcinated at the same temperature for 5 hours, so that the phosphor ceramic sheet 4 having a thickness of 100 µm was produced (ref: FIG. 1B).

### (Through Hole Forming Step)

The plurality of through holes 2 were formed in the phosphor ceramic sheet 4.

By using a PHAROS ultrashort pulse laser (picosecond laser, manufactured by Light Conversion Ltd.), a size of the applied beam diameter was set at 4 mmϕ and punched at 600 uJ (ref: FIGS. 1C and 7).

The through hole 2 has a generally rectangular shape when viewed from the top, the length (W1, W2) of each of the sides was 0.40 mm, the radius of curvature (R) of the edge portion 8 was 0.1 mm, and the inclination angle (θ) of the end surface was 67 degrees. The pitch (W3) of the through hole 2 was 2.1 mm.

### (Cutting Step)

Thereafter, the phosphor ceramic sheet 4 was temporarily fixed to the supporting sheet 5 made of a dicing tape.

Next, the laminated sheet was set on a dicing device including a dicing saw (manufactured by DISCO Corporation, "DFD6361") and cut so as to go through the center of the through hole with the dicing saw 6 having a blade thickness of 40 µm to be singulated (ref: FIG. 1D).

The length (L1, L2) of each of the sides of the obtained phosphor ceramic plate 1 was 1.0 mm, and the length (D1, D2) of each of the sides of the cut-out portion 7 was 0.18 mm.

### Example 2

In the through hole forming step, the phosphor ceramic plate 1 was produced in the same manner as in Example 1, except that direct pressure blasting process was performed instead of the ultrashort pulse laser processing (ref: FIG. 2).

That is, in the through hole forming step, a resist film adhered onto the phosphor ceramic sheet 4 to be subjected to patterning light exposure so as to form the predetermined through hole 2. Next, by using a direct pressure alumina blasting process device (manufactured by NICCHU CO., LTD., trade name: "PAM102"), blasting by alumina particles was performed.

The through hole 2 was a generally rectangular shape when viewed from the top, and the length (W1, W2) of each of the sides was 0.40 mm, the radius of curvature (R) of the edge portion 8 was 0.1 mm, and the inclination angle (θ) of the end surface was 79 degrees.

The length (L1, L2) of each of the sides of the obtained phosphor ceramic plate 1 was 1.0 mm, and the length (D1, D2) of each of the sides of the cut-out portion 7 was 0.18 mm.

### Example 3

In the through hole forming step, the phosphor ceramic plate 1 was produced in the same manner as in Example 1, except that siphon blasting was performed instead of the ultrashort pulse laser processing (ref: FIG. 2).

That is, in the through hole forming step, a resist film was adhered onto the phosphor ceramic sheet 4 to be subjected to patterning light exposure so as to form the predetermined through hole 2. Next, by using a siphon alumina blasting device (manufactured by NICCHU CO., LTD., trade name: "PAM102"), blasting by alumina particles was performed.

The through hole 2 was a generally rectangular shape when viewed from the top, and the length (W1, W2) of each of the sides was 0.40 mm, the radius of curvature (R) of the edge portion 8 was 0.1 mm, and the inclination angle (θ) of the end surface was 46 degrees.

The length (L1, L2) of each of the sides of the obtained phosphor ceramic plate 1 was 1.0 mm, and the length (D1, D2) of each of the sides of the cut-out portion 7 was 0.18 mm.

### Example 4

The phosphor ceramic plate 1 was produced in the same manner as in Example 2, except that the blasting was performed in the cutting step in addition to the through hole forming step.

The through hole 2 was a generally rectangular shape when viewed from the top, and the length (W1, W2) of each of the sides was 0.40 mm, the radius of curvature (R) of the edge portion 8 was 0.1 mm, and the inclination angle (θ) of the end surface, the first side surface 18, and the second side surface 19 was 79 degrees.

The length (L1, L2) of each of the sides of the obtained phosphor ceramic plate 1 was 1.0 mm, and the length (D1, D2) of each of the sides of the cut-out portion 7 was 0.18 mm.

### Comparative Example 1

In Example 1, after the preparing step, the phosphor ceramic sheet 4 was temporarily fixed to the supporting sheet 5 made of a dicing tape, and by cutting the laminated sheet at a pitch of 1.05 mm in the front-rear and right-left directions with a dicing saw having a blade thickness of 40 µm, the phosphor ceramic plate 1 in a generally square shape when viewed from the top having one side of 1.0 mm was produced.

Next, the edge of the phosphor ceramic plate 1 was cut with a V-shaped blade at 90 degrees (manufactured by DISCO Corporation, "B1E8 series", blade thickness of 100 µm), thereby forming the cut-out portion.

In the obtained phosphor ceramic plate 1, the length (W1, W2) of each of the sides of the cut-put portion 7 was 0.18 mm, the angle of the edge portion 8 of the cut-out portion 7 was a generally right angle shape (90 degrees) when viewed from the top, and the inclination angle (θ) of the end surface was 90 degrees.

### Comparative Example 2

The phosphor ceramic plate 1 was produced in the same manner as in Comparative Example 1, except that the cut-out portion was formed by using a trapezoidal blade (manufactured by DISCO Corporation, "B1N8 series", blade thickness of 100 µm) instead of using the V-shaped blade at 90 degrees (manufactured by DISCO Corporation, "B1E8 series", blade thickness of 100 µm).

In the obtained phosphor ceramic plate 1, the length (D1) of each of the sides of the cut-out portion 7 was 0.18 mm, the radius of curvature (R) of the edge portion 8 of the cut-out portion 7 was 0.1 mm, and the inclination angle (θ) of the end surface was 90 degrees.

### <Production of Optical Semiconductor Device of First Embodiment>

A cavity-including multi-layer ceramic board (manufactured by Sumitomo Metal Electronics Devices Inc., part number: "207806", housing height of 0.6 mmt, housing material alumina, reflection rate of 75%) was prepared. A one wire-type blue light emitting diode chip (optical semiconductor element, thickness of 100 µm) having a length of one side of 40 mil (1.0 mm) in a square shape when viewed from the top and in which the connecting portion 27 was formed in one edge portion (corner) of the upper surface thereof was prepared. A diode chip 28 was die-attached to the multi-layer ceramic board 26 with Au-Sn solder, thereby producing the element-including board 30.

Each of the phosphor ceramic plates 1 of Examples was disposed on the upper surface of the blue light emitting diode chip 28 so that the connecting portion 27 was exposed and the end surface 3 of the phosphor ceramic plate 1 with respect to the upper surface of the diode chip was an acute angle (θ).

Next, the connecting portion 27 was wire bonded to the terminal portion 25 of the multi-layer ceramic board 26 by an Au wire, thereby producing the optical semiconductor device 20 of the first embodiment.

### <Production of Optical Semiconductor Device of Comparative Example>

The optical semiconductor device 20 of Comparative Example was produced in the same manner, except that in the above-described <Production of Optical Semiconductor Device of First Embodiment>, each of the phosphor ceramic plates 1 of Comparative Examples was used instead of each of the phosphor ceramic plates 1 of Examples.

### (Evaluation of Visibility)

In the production of the optical semiconductor device described above, when the phosphor ceramic plate 1 was disposed on the upper surface of the blue light emitting diode chip 28, the connecting portion 27 was observed at the angle of 90 degrees and 65 degrees in a vertical direction with a microscope (manufactured by KEYENCE CORPORATION, "digital microscope VHX-2000"), and the surface of the connecting portion 27 was photographed. The ratio (area at 65 degrees/area at 90 degrees) of the area that could be visually confirmed at 65 degrees of the connecting portion 27 to the area that could be visually confirmed at 90 degrees thereof was calculated. A case where the ratio was 98% or more was defined as "Good", and a case where the ratio was below 98% was defined as "Bad". The results are shown in Table 1.

### (Evaluation of Light Emitting Properties)

The light reflective layer 31 was formed so that the entire wire 29 was sealed and the upper surface of the phosphor ceramic plate 1 was exposed with respect to the above-described optical semiconductor device by using a liquid reflective resin composition containing a silicone resin and alumina.

Next, in the end surface 3 of the cut-out portion 7, the length L in the right-left direction of a portion covered with the light reflective layer 31 (ref: FIG. 4C) was measured. A case where the length L with respect to the thickness T1 of the phosphor ceramic plate 1 was short was evaluated as "Good" because the area of the change of color occurred at the peripheral end edge was small; a case where the length L was almost equal to the thickness T1 was evaluated as "Poor"; and a case where the length L with respect to the thickness T1 was long was evaluated as "Bad" because the area of the change of color occurred at the peripheral end edge was large. The results are shown in Table 1.

### <Production of Optical Semiconductor Device of Second Embodiment and Evaluation of Wire Contact Properties>

The element-including board 30 was produced in the same manner as in the optical semiconductor device 20 of the first embodiment. Next, the connecting portion 27 was wire bonded to the terminal portion 25 of the multi-layer ceramic board 26 with an Au wire.

Next, each of the phosphor ceramic plates 1 of Examples was disposed on the upper surface of the diode chip 28 so that the connecting portion 27 was exposed and the end surface of the phosphor ceramic plate 1 with respect to the upper surface of the diode chip 28 was an obtuse angle (θ'). In this manner, the optical semiconductor device 20 of the second embodiment was produced.

When the phosphor ceramic plate 1 was disposed on the upper surface of the diode chip 28, the arrangement was performed to deviate from the normal alignment position by 25 µm in one of the directions of the front-rear direction and the right-left direction, and in a direction approaching the wire.

At this time, by using a microscope (manufactured by KEYENCE CORPORATION, "digital microscope VHX-2000"), the wire near the terminal portion of the optical semiconductor device was observed. A case where the phosphor ceramic plate was not in contact with the wire was evaluated as "Good", and a case where the phosphor ceramic plate was in contact with the wire was evaluated as "Bad".

As for each of the phosphor ceramic plates 1 of Comparative Examples, the operation was performed in the same manner as described above to be evaluated. The results are shown in Table 1.

### (Crack Evaluation)

In each of the cutting steps of Examples and Comparative Examples, by cutting the phosphor ceramic sheet 4 in a high speed mode, the phosphor ceramic plate 1 was produced.

A case where a crack did not occur in the phosphor ceramic plate 1 was evaluated as "Good", and a case where a crack occurred was evaluated as "Bad". The results are shown in Table 1.

**[Table 1]**

| Phosphor Ceramic Plate | | EX. 1 | Ex. 2 | EX. 3 | EX. 4 | EX. 1 | Ex. 2 | Ex. 3 | Ex. 4 | Comp. Ex.1 | Comp. Ex. 2 |
|---|---|---|---|---|---|---|---|---|---|---|---|
| Semiconductor Device | | Optical Semiconductor Device of First Embodiment | | | | Optical Semiconductor Device of Second Embodiment | | | | Optical Semiconductor Device of Comp. Ex. | |
| Figures | | FIG. 4C | FIG. 4C | FIG. 4C | FIG. 9A | FIG. 6C | FIG. 6C | FIG. 6C | FIG. 9B | FIG. 10 | FIG. 10 |
| θ or θ' | | 67° (θ) | 79° (θ) | 46° (θ) | 79° (θ) | 113° (θ') | 101° (θ') | 134° (θ') | 101° (θ') | 90° | 90° |
| Curved Shape of Cut-Out Portion | | Presence | Presence | Presence | Presence | Presence | Presence | Presence | Presence | Absence | Presence |
| Evaluation | Visibility | Good | Good | Good | Good | - | - | - | - | Bad | Bad |
| | Light Emitting Properties | Good | Good | Poor | Good | - | - | - | - | Good | Good |
| | Wire Contact Properties | - | - | - | - | Good | Good | Good | Good | Bad | Bad |
| | Crack Properties | Good | Good | Good | Good | Good | Good | Good | Good | Bad | Good |

While the illustrative embodiments of the present invention are provided in the above description, such is for illustrative purpose only and it is not to be construed as limiting the scope of the present invention. Modification and variation of the present invention that will be obvious to those skilled in the art is to be covered by the following claims.

### Industrial Applicability

The ceramic plate of the present invention is, for example, used in the production of the optical semiconductor device.

### Description of Reference Numerals

- 1: Phosphor ceramic plate
- 2: Through hole
- 3: End surface
- 4: Phosphor ceramic sheet
- 7: Cut-out portion
- 18: First side surface
- 19: Second side surface
- 20: Optical semiconductor device
- 28: Optical semiconductor element

## Claims

1. A ceramic plate having a flat plate shape comprising:
a cut-out portion that is cut out inwardly from a peripheral end surface, wherein
an end surface defining the cut-put portion inclines in a thickness direction of the ceramic plate.

2. The ceramic plate according to claim 1, wherein
as an inclination angle of the end surface, one of the angles formed between the end surface and the upper surface or the lower surface of the ceramic plate is 30 degrees or more and 89 degrees or less.

3. The ceramic plate according to claim 1, wherein
the end surface has a curved shape when viewed from the top.

4. An optical semiconductor device comprising:
an optical semiconductor element and
the ceramic plate according to claim 1 disposed on one surface of the optical semiconductor element.

5. The optical semiconductor device according to claim 4, wherein
the ceramic plate is disposed on one surface of the optical semiconductor element so that an angle formed between one surface of the optical semiconductor element and the end surface is an acute angle.

6. The optical semiconductor device according to claim 4, wherein
the ceramic plate is disposed on one surface of the optical semiconductor element so that an angle formed between one surface of the optical semiconductor element and the end surface is an obtuse angle.

7. A method for producing a ceramic plate sequentially comprising the steps of:
preparing a ceramic sheet,
forming a through hole in the ceramic sheet and exposing an end surface defining the through hole, and
cutting the ceramic sheet to form a plurality of ceramic plates including the end surface, wherein
the end surface inclines in a thickness direction of the ceramic sheet.

8. The method for producing a ceramic plate according to claim 7, wherein
a side surface exposed at the time of cutting the ceramic sheet inclines in the thickness direction of the ceramic sheet.
